# EUROPEAN PATENT APPLICATION

(11) **EP 1 995 584 A2**
(43) Date of publication of application: **26.11.2008**
(21) Application number: 08009532.6
(22) Date of filing: 25.05.2008
(51) Int. Cl.: G01N 1/14, G01N 1/38, G01N 1/42

(54) **Solid sample, solid sample fabricating method and solid sample fabricating apparatus**

(30) Priority: 25.05.2007 JP 2007139371
(71) Applicant: Canon Kabushiki Kaisha, Ohta-ku Tokyo (JP)
(72) Inventor: Yokoi, Hideto, Ohta-ku Tokyo (JP); Motoi, Taiko, Ohta-ku Tokyo (JP); Suzuki, Tomoko, Ohta-ku Tokyo (JP)
(74) Representative: Weser, Thilo

(57) **Abstract**

A solid sample fabricating method includes preparing a specimen containing a first substance (61), which is in a liquid phase at normal temperature and normal pressure, and a second substance (62) different from the first substance, which is in a solid or a liquid phase at the normal temperature and the normal pressure, the second substance being dispersed in the first substance, and attaching the specimen as a droplet to a surface of a cooled stage (1), whereby an entire region to be observed is converted into an amorphous state.

## Description

### BACKGROUND OF THE INVENTION

### Field of the Invention

The present invention relates to a solid sample that allows the dispersion state of a substance, which is dispersed in a liquid, to be observed with a higher level of accuracy, and to methods of fabricating and observing the solid sample. Also, the present invention relates to apparatuses for use with the solid sample fabricating and observing methods.

### Description of the Related Art

With a recent increase in needs for functional devices, there is a demand for a more accurate evaluation and a finer structural analysis of the dispersion state of a sample in which a solid or liquid substance is dispersed in a liquid medium, such as drugs and emulsions.

An SEM (Scanning Electron Microscope) is generally used to observe structures smaller than those observable by an optical microscope. However, since the SEM requires a sample to be placed in a vacuum, an ordinary sample cannot be observed in a liquid state. Therefore, when a liquid sample is observed, it needs to be fixed so as not to change even in a vacuum. When a target is observed in a stationary state, including via the SEM, a liquid sample has to be fixed by a certain method.

One of the conventional methods of observing a dispersed substance in the liquid sample so that the distribution density, as well as the aggregation and dispersion states in the liquid phase, are maintained is freezing and solidifying a liquid sample.

When the liquid sample is frozen and solidified, the solidification often progresses while a crystallization surface migrates in the sample. In such a case, the dispersed substance also migrates in the liquid medium with the migration of the crystallization surface. Accordingly, the dispersion state of the dispersed substance in the solidified sample differs from that in the state of the liquid before the freezing, and the dispersed substance in the liquid sample cannot be accurately observed.

Japanese Utility Model Laid-Open No. 57-75554 proposes a method of rapidly cooling a liquid sample by putting the liquid sample in a sample holder and pressing the sample holder onto a cooled metal block. However, the proposed method requires the sample to be removed from the holder and transferred onto a stage of a machining and observing apparatus when the sample is observed. Further, when the sample is very small, it is difficult to make the heat capacity of the holder smaller than that of the sample. For that reason, sample cooling conditions are varied depending on the heat capacity of the holder, and a frozen sample cannot be obtained in such a state that the sample to be observed is entirely uniform.

Also, Japanese Patent Publication No. 08-12136 discloses a method of rapidly cooling a sample immediately after irradiating it with microwaves, thereby freezing and solidifying the sample. The reason for utilizing the microwaves is that, in a conventional rapid freezing apparatus, a region where water is frozen in the amorphous state is limited to a portion that is at most about 20 µm from the sample surface held in contact with a copper block.

Thus, Japanese Patent Publication No. 08-12136 discloses that the irradiation of the microwaves impedes the growth of an ice crystal and greatly increases the region in which water is frozen in an amorphous state.

In that method, however, because the energy is provided to the sample externally by the microwaves and an artificial dispersion state is formed, the dispersion state of a resulting solid sample differs from the genuine dispersion state of the original liquid sample. Further, the liquid sample cannot be entirely incorporated into a solid sample in an amorphous state.

Regardless, as described above, when observing the sample, the sample has to be removed from the holder and transferred onto the stage of the machining and observing apparatus. Further, if the sample is very small, because it is difficult to make the heat capacity of the holder smaller than that of the sample, sample cooling conditions are varied depending on the heat capacity of the holder, and an entirely uniform solid sample cannot be obtained.

### SUMMARY OF THE INVENTION

The present invention provides a solid sample enabling the dispersion state of a solid or liquid dispersive substance in a liquid to be observed with a higher level of accuracy, and methods of fabricating and observing the solid sample.

Also, the present invention provides a solid sample fabricating apparatus and a solid sample observing apparatus for use with those methods.

The present invention in its first aspect provides a solid sample as specified in claims 1 to 4.

The present invention in its second aspect provides a solid sample fabricating method as specified in claims 5 to 7.

The present invention in its third aspect provides a sample observing method as specified in claims 8 and 9.

The present invention in its fourth aspect provides a solid sample fabricating apparatus as specified in claims 10 to 14.

The present invention in its fifth aspect provides an observing apparatus as specified in claim 15.

The present invention in its sixth aspect provides a solid sample as specified in claim 16.

According to the present invention, since the solid sample is prepared by solidifying the liquid sample in the amorphous state in its entirety while maintaining the dispersion state of the dispersed substance in the liquid phase, the dispersion state of the dispersed substance in the liquid phase can be accurately observed.

Further, according to the present invention, since the sample is ejected at a high speed in the form of a very small droplet that lands in the form of a very thin film on the cooled sample stage, the entire sample can be rapidly cooled and the solid sample can be obtained without irradiating microwaves, as a solid in which the entire sample is in the amorphous state and maintains the dispersion state in the liquid phase.

Further features of the present invention will become apparent from the following description of exemplary embodiments with reference to the attached drawings.

### BRIEF DESCRIPTION OF THE DRAWINGS

Fig. 1 is a schematic view illustrating a construction of a sample fabricating station according to one exemplary embodiment of the present invention.

Fig. 2 is a flowchart illustrating a sample fabricating procedure according to the exemplary embodiment of the present invention shown in Fig. 1.

Figs. 3A-3C are schematic views illustrating a step of replacing nitrogen gas in the apparatus as a part of the sample fabricating procedure according to exemplary embodiment of the present invention shown in Fig. 1.

Figs. 4A-4D are schematic views illustrating a step of contacting a sample with a stage and solidifying the sample as a part of the sample fabricating procedure according to the exemplary embodiment of the present invention shown in Fig. 1.

Figs. 5A-5C are schematic views illustrating a step of transferring the solidified sample to another apparatus as a part of the sample fabricating procedure according to the exemplary embodiment of the present invention shown in Fig. 1.

Fig. 6 is a schematic view illustrating a construction of an apparatus for fabricating and observing the sample according to an exemplary embodiment of the present invention.

Fig. 7A is a schematic view illustrating one example of a processed sample, and Fig. 7B is a schematic view illustrating SEM observation of a sample cross-section.

Fig. 8A is a schematic view illustrating another example of the processed sample, and Fig. 8B is a schematic view illustrating an SEM observation of a sample cross-section.

Fig. 9 is a schematic view illustrating a construction of an apparatus for fabricating and observing the sample according to another exemplary embodiment of the present invention.

Fig. 10 is a schematic view illustrating a construction of a sample observing apparatus according to still another exemplary embodiment of the present invention.

Fig. 11 illustrates an SEM image in a processed sample cross-section.

Fig. 12 is a flowchart illustrating a sample fabricating and observing procedure according to still another exemplary embodiment of the present invention.

Figs. 13A and 13B are each a schematic view illustrating an example of a processed sample.

Figs. 14A and 14B are each a schematic view illustrating another example of the processed sample.

Fig. 15 is a flowchart illustrating a part of the sample fabricating procedure.

### DESCRIPTION OF THE EMBODIMENTS

### Solid Sample

In a solid sample according to the present invention, an entire region to be observed is solidified in an amorphous state. The amorphous solid is a solid in which random molecular arrangement of a liquid is frozen as it is. This state can be obtained by rapidly cooling a specimen droplet of a liquid sample in such a manner that crystal growth is impeded.

When a substance is dispersed in a liquid sample, its migration with the growth of a crystal surface can be avoided because the crystal surface is not generated as a result of solidifying the liquid sample in the amorphous state. In addition, because the sample is not irradiated with microwave energy before the solidification, the obtained solid sample correctly reflects the dispersion state of the substance dispersed in the liquid phase. Accordingly, an accurate distribution observation of the substance as it was dispersed in the liquid phase can be performed by observing the solid sample by, e.g., the SEM.

Whether the solid sample is in the amorphous state can be determined, for example, by direct observation using, e.g., an optical microscope, an SEM, or a laser microscope, or by measuring a diffraction pattern with a transmissive electron microscope or an X-ray analysis. If there is some crystalline portion, crystals of a certain mass can be directly observed by using the SEM, and a diffraction pattern specific to the crystalline portion can be measured by employing the transmissive electron microscope or the X-ray analysis. In addition, Raman spectroscopy can also be used to identify whether the sample is in the amorphous state or the crystalline state.

The amorphous state of the solid sample in accordance with the present invention refers to a state where any crystal having a particle size of 10 nm or more is not observed, for example, by the SEM.

A first substance or liquid (A) in accordance with the present invention is in a liquid phase at normal temperature and normal pressure. The normal temperature is about 20°C and the normal pressure is one atmosphere. Typical examples of such a first substance include water, a water-soluble solvent, and an organic solvent.

The organic solvent used in the present invention can be selected from among alcohols such as ethanol, methanol and isopropanol; acetone; ethyl ether; xylene; cyclohexane; and toluene.

A second substance (B) in accordance with the present invention is in a solid or a liquid phase at normal temperature and normal pressure, which are noted above.

A substance (B1), which is in a solid phase at normal temperature and normal pressure as noted above, can be selected from among pure metals, such as gold, silver, copper and alloys thereof, semiconductors, such as silicon and germanium, oxides, such as silicon oxide, titanium oxide, aluminum oxide, zinc oxide, and zirconium oxide, and inorganic micro-particles, such as carbon black.

Other examples of the substance (B1) include organic micro-particles made of organic compounds, such as an anthraquinone derivative and a polystyrene resin; and metallic complexes, such as copper phthalocyanine.

The particle size of the substance (B1) is not particularly limited so long as satisfactory dispersivity in a liquid is maintained. Particle size can range from 10 nm to 1 µm and, more advantageously, from 10 nm to 100 nm.

The particle size of the substance (B1) can be measured, e.g., by a light scattering method or a laser diffraction method.

A substance (B2), which is in a liquid phase at normal temperature and normal pressure, is not particularly limited so long as it is in a liquid phase and is solidified together with the liquid (A) to form a solid by rapid cooling. However, the substance (B2) must be able to maintain its dispersed state in the liquid (A).

More specifically, the substance (B2) is a liquid in an emulsion state, such as a protein dispersed solution or a not-yet-reacted emulsified polymerization liquid. The particle size of the liquid substance (B2) can be selected, as appropriate, from 10 nm to 1 µm and, more advantageously, from 10 nm to 100 nm.

The particle size of the substance (B2) can be measured, e.g., by a light scattering method or a laser diffraction method.

The substance (B), which is in a solid or a liquid phase at normal temperature and normal pressure, can have the function of a pigment, a colorant, an electro-conductive substance, an insulating substance, a semiconductor, a dielectric, a magnetic substance, an emulsion, or a surfactant.

Further, the substance (B) can be, e.g., a substance having a solidifying point of -40°C or higher, and, more preferably, from -40°C to +20°C. Practical examples of the substance (B) include cyclohexane and vegetable fat and oil.

The liquid sample (AB) used as a specimen in the present invention is, for example, a pigment ink composition in which a pigment is dispersed, an electro-conductive paste composition in which silver particles are disposed in an organic solvent containing a dissolved thermosetting resin, or a solution in which chargeable particles are dispersed.

### Solid Sample Fabricating Method

A method for preparing a solid sample in accordance with the present invention includes cooling a stage in advance and ejecting a specimen droplet, which has a predetermined volume within the range allowing a conversion to an amorphous state, from an ejecting apparatus so that it lands on the cooled stage, whereby the droplet is rapidly cooled and solidified in the amorphous state.

The solidifying step can be performed in a dried gas atmosphere. This atmosphere is effective in preventing dew condensation on the sample surface when the droplet is rapidly cooled to be solidified by freezing.

It is advantageous for the dried gas atmosphere to have a dew point in the range of -273 to -196°C.

The dried gas is not particularly limited so long as it has a low moisture content. While the dried gas preferably contains at least one of the inert gases selected from nitrogen and noble gases, such as helium and argon, a reactive gas, such as hydrogen, can also be used.

The successive process steps involved in the formation of the solid sample in accordance with the present invention are described below.

First, the stage is cooled in advance to provide a landing point for a droplet of the liquid (A) containing the substance (B), i.e., the liquid sample (AB) as a specimen.

The stage is a sample stand used for solidifying the liquid sample (AB) by freezing, and it is cooled in advance, for example, by a cooler.

The thermal conductivity of the stage employed in the present invention is only required to be sufficient for the droplet to be frozen in a short period of time to become an amorphous solid sample. For example, the stage can be formed of a member with a surface made of a metallic material, such as aluminum, an aluminum alloy, copper, or a copper alloy. In addition, a thin insulating coating, such as a metal oxide, can also be formed on the surface of the metallic material.

The cooler for cooling the stage can be, for example, a Dewar vessel containing a coolant, e.g., liquid nitrogen, or a cooling chamber held at a low temperature. Alternatively, the cooler can be a metal mass having been cooled to a low temperature, or a cooling mechanism, such as a Peltier device or a helium refrigerator.

By cooling the stage to the temperature of liquid nitrogen (-196°C), the droplet of the liquid sample (AB) is rapidly cooled when it lands on the stage and the entire sample to be observed is converted into an amorphous state without forming a crystalline portion.

Even when liquid nitrogen is not used, an amorphous solid sample can be obtained. If the liquid is water, for example, because the glass transition point of water at the pressure of one atmosphere is about -130°C, an amorphous solid sample can be obtained when the stage temperature is reduced to about -140°C or less.

In the method of forming a solid sample according to the present invention, because the sample holder of the related art is not used, only the droplet is required to be frozen without cooling the sample holder. In particular, the stage is not required to be cooled to a temperature that is lower than that needed for freezing only the droplet.

Next, the liquid sample (AB) is ejected from a specimen supply unit as a droplet sized within the range that allows it to be converted to the amorphous state over an entire region to be observed, such that the droplet lands on the stage that was cooled in advance by the cooler.

The stage used in the present invention can include a moving mechanism for moving the stage surface in a direction intersecting the ejecting direction of the droplet so that a plurality of droplets are spaced apart from each other and attached to the stage surface. A plurality of amorphous solid samples are thus obtained.

In practice, the stage is constructed to be movable in a direction crossing the ejecting direction of the droplet, more preferably in a direction perpendicular to the ejecting direction of the droplet. By moving the stage in the direction perpendicular to the ejecting direction when the droplet is ejected, a plurality of amorphous solid samples having substantially the same shape and size are obtained.

Further, by constructing the stage to be separable from the cooler, the stage can be freely moved after it has been cooled in advance by the cooler. Also, a plurality of droplets can be placed at desired positions on the stage.

In addition, the viscosity, the flying speed, the volume, and the flying distance of each droplet are also advantageously adjusted for the purpose of converting the entire droplet that lands on the stage into the amorphous state. It should be noted that the thickness of a thin film formed from the droplet is not required to be uniform.

By ejecting the droplet to strike against the stage at a high speed, the droplet spreads on the stage and becomes a thin coating, which is then cooled.

In the present invention, the droplet that lands on the stage can have a volume of 100 pl (pico liter) or less at a flying speed of 5 m/sec or more. For example, the volume of the droplet is 10 pl and the flying sped of the droplet is 7 m/sec.

By making the thickness of the thin coating sufficiently small, heat transfer from the thin coating to the stage occurs in a short period of time. Liquid molecules in the droplet-shaped sample (AB) substantially solidify in a very short period of time. The substance (B), i.e., the dispersive substance having a much larger size than molecules, can hardly spatially migrate within that period of time.

As a result, the pre-solidification dispersion state of the substance (B) is maintained. In the case of a water-based liquid, the properties of the liquid sample (AB) are selected so as to have a surface tension of 70 mN/m or less and a viscosity of 1 x 10⁻² Pa·s or less from the viewpoint of forming a thin film on the stage.

The thickness of the thin film formed by the droplet landing on the stage can be in the range of 1 µm to 50 µm and, more preferably, from 1 µm to 10 µm. If the thickness of the thin film is in that range, a solid sample entirely made of an amorphous solid can be easily formed. Further, unlike in the prior art, even if the size of the observation region exceeds 20 µm from the droplet landing surface, e.g., a size in the range of 25 µm to 50 µm, this region can be entirely in an amorphous state.

When the volume of the droplet is large, a thin film is not formed on the stage and the droplet is attached onto the stage as a rising-shaped droplet having a large contact angle. In such a case, because the liquid volume is larger in comparison with the contact area between the droplet and the stage and the heat transfer takes a longer period of time, particles migrate in the liquid during the cooling step, thus causing a change in the dispersion state.

Further, even with the droplet having a small volume, when the flying speed is slow, a sufficiently thin film may not form on the stage. If so, the dispersion state is also apt to change even when the liquid volume is small. Usually, the volume and the flying speed of the droplet are appropriately adjusted in the range of 0.1 pl to 1 nl and the range of 3 m·s⁻¹ to 20 m·s⁻¹, respectively, from the viewpoint of forming a uniform thin film.

The specimen supply unit used in the present invention can be a liquid jet head, which ejects a liquid in the form of a droplet. Such a liquid jet head is to eject the droplet through a nozzle (ejection orifice), and it is called an ink jet head.

Although the wording "ink jet" is used here, it should be understood that the ejected liquid in accordance with the present invention is not limited to ink.

The ink jet head is suitable for forming a minute droplet and can adjust the volume and the flying speed of the droplet. For that reason, the ink jet head is suitable for fabricating the solid sample according to the present invention. The ink jet head can be, for example, of the thermal, piezo-electric, or electrostatic type.

In addition to the liquid jet head, the specimen supply unit used in the present invention can also be formed of a micro-pipette or a hollow tube, e.g., a capillary.

Further, the stage can be moved relative to the cooler such that the droplet lands on the stage after the stage has departed from the cooler. The heat of solidification generated when the landed droplet is solidified is sufficiently small in comparison with the heat capacity of the stage. Accordingly, the entire droplet can be converted into the amorphous state even when the droplet lands on the stage after the stage has moved away from the cooler.

### Sample Observing Method

A sample observing method according to the present invention includes fabricating a solid sample by using the above-described sample fabricating method and observing a cross-section of the solid sample.

Further, the sample observing method includes forming a cross-section of the exposed solid sample, and observing the exposed cross-section after selectively evaporating and removing a part of the liquid (A) from the solid sample.

To that end, the solid sample is irradiated with a low energy electron beam to remove at least a part of the water, i.e., the liquid (A). As a result, the substance (B) dispersed in the liquid (A) appears as projections on the cross-section of the solid sample. Hence, the cross-section of the solid sample can be observed with a higher contrast.

In the machining and observing steps, the stage can be moved from a solid sample fabricating apparatus to a machining apparatus or a machining and observing apparatus in which the solid sample is machined and/or observed, while the solid sample is kept in place on the stage.

To avoid the temperature of the solid sample from changing during the movement, a temperature holding mechanism can be added to the stage.

An observing apparatus according to the present invention includes the above-described solid sample fabricating apparatus, a cross-section forming apparatus configured to machine the solid sample, which has been fabricated by the fabricating apparatus, thereby forming a cross-section, and a cross-section observing apparatus configured to observe the cross-section formed by the cross-section forming apparatus while maintaining the amorphous state of the solid sample.

In practice, the solid sample fabricating apparatus can include an FIB (Focused Ion Beam) machining apparatus configured to machine the solid sample and to form the cross-section, and an SEM (Scanning Electron Microscope) apparatus configured to observe the cross-section.

Each of the FIB machining apparatus and the SEM apparatus can be a commercially available unit. Also, the sample observing apparatus can be prepared by combining the solid sample fabricating apparatus with an FIB-SEM apparatus, which is provided by adding the FIB machining function to the SEM apparatus.

The sample observing apparatus can further include, e.g., an X-ray microanalyzer and/or an Auger electron spectrometer. The types of elements constituting the solid sample can be confirmed by using those apparatuses. In other words, a plurality of particles containing different elements, which cannot be discriminated from one another based solely on shapes, can be discriminated based on their elements.

### First Exemplary Embodiment

A first exemplary embodiment of the present invention is described below with reference to the drawings. Sample Fabricating Apparatus 1

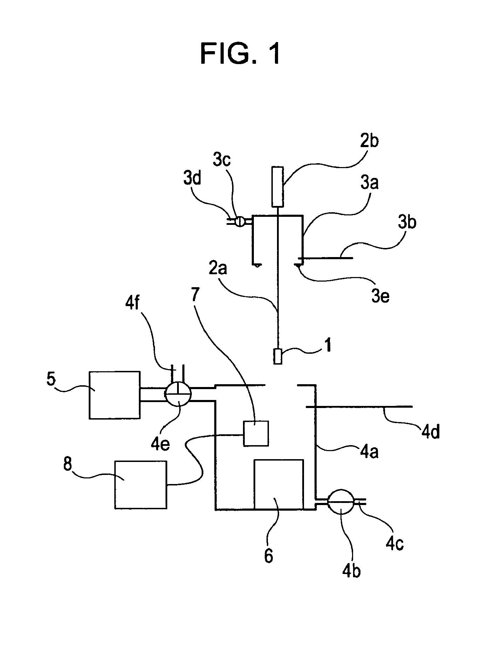

Fig. 1 illustrates one example of the sample fabricating apparatus according to the present invention in which a liquid jet head is employed as a specimen supply unit.

A stage 1 on which a sample is placed is attached to an introduction rod 2a, and an operating portion 2b is connected to a top end of the introduction rod 2a. The stage 1 can be made of a substance that has a large specific heat and high thermal conductivity, specifically a metal such as aluminum or copper. A thin aluminum oxide film can be formed on the surface of the stage 1.

A temperature sensor (not shown) is built in the stage 1 such that it can be connected from the interior of the introduction rod 2a to a temperature display unit or an externally installed temperature controller (not shown).

The stage 1 is extended from a first chamber 3a (hereinafter referred to as a "chamber B") through the introduction rod 2a and is vertically movable by the operating portion 2b. When the introduction rod 2a is contracted, the stage is entirely accommodated in the chamber B. The introduction rod 2a and the operating portion 2b constitute a moving mechanism for moving the stage such that the stage can be vertically moved at a constant speed and can be fixed at a desired position.

The introduction rod 2a penetrates the chamber B through a through-hole and an O-ring (not shown), which are disposed at a top wall of the chamber B in such a manner that the introduction rod 2a can slide while maintaining air-tightness. The chamber B includes a chamber hatch 3b serving to isolate an inner space of the chamber B in an airtight state.

A purge gas introduction port 3d associated with a purge gas opening/closing valve 3c is mounted on the chamber B so as to face the chamber space at a more internal position than the chamber hatch 3b. Further, the chamber B is opened at its bottom and includes an O-ring 3e disposed around a bottom opening to air-tightly enclose a portion of the chamber B, which contacts a second chamber 4a (described below).

Below the chamber B, a unit for cooling the stage 1 and a unit for ejecting the sample in the form of a droplet toward the stage 1 are disposed inside the second chamber 4a (hereinafter referred to as an "chamber A").

The chamber A includes a chamber hatch 4d capable of isolating a part of an inner space of the chamber A in an airtight state. A purge gas introduction port 4c associated with a purge gas opening/closing valve 4b is mounted on the chamber A so as to face the chamber space at a more internal position than the chamber hatch 3b. Further, the chamber A is selectively connected to a leak port 4f and a vacuum pump 5 through a selector valve 4e. By operating the selector valve 4e, it is possible to expose the inner space of the chamber A to open air, or to let air only in the vacuum pump 5 to leak when the vacuum pump 5 is stopped.

Inside the chamber A, a Dewar vessel 6 containing a required amount of a coolant is used as a cooler for the sample stage 1. Liquid nitrogen can be used as the coolant. A cooling unit is not limited to the Dewar vessel containing the coolant. It can also be, for example, a cooling chamber held at a low temperature. Alternatively, the cooling unit can be a member with which the stage is contacted for cooling, e.g., a metal mass having been cooled to a low temperature. Further, a cooling mechanism, such as a Peltier device or a helium refrigerator, can also be used.

A specimen supply unit 7 for ejecting the liquid sample (AB) in the form of a droplet is disposed inside the chamber A. The specimen supply unit 7 herein is a liquid jet head for ejecting a sample in a liquid state in the form of a droplet toward the stage at a predetermined speed.

The ejection orifice size and ejection energy of the liquid jet head 7 are appropriately selected depending on the volume and the flying speed of the droplet. The head 7 is connected to an ejection controller 8 which sets the ejection timing and the ejection time interval. The volume of the droplet and the flying speed thereof at the time of landing on the stage surface are selected as described above.

A droplet needs not to be ejected using the liquid jet head. The deposition process can be performed by propelling a certain volume of a sample liquid through an ejection orifice, such as a hollow tube, by a positive pressure, and a droplet may be formed using gravity when the liquid drips toward the stage 1. In such a case, the droplet speed is determined depending on the dropping distance.

The ejection controller 8 includes a mechanism for detecting the position of the stage 1 and controls the ejection timing in conjunction with the detecting mechanism so that the liquid sample (AB) lands at a predetermined position on the stage 1.

### Sample Fabricating Method 1

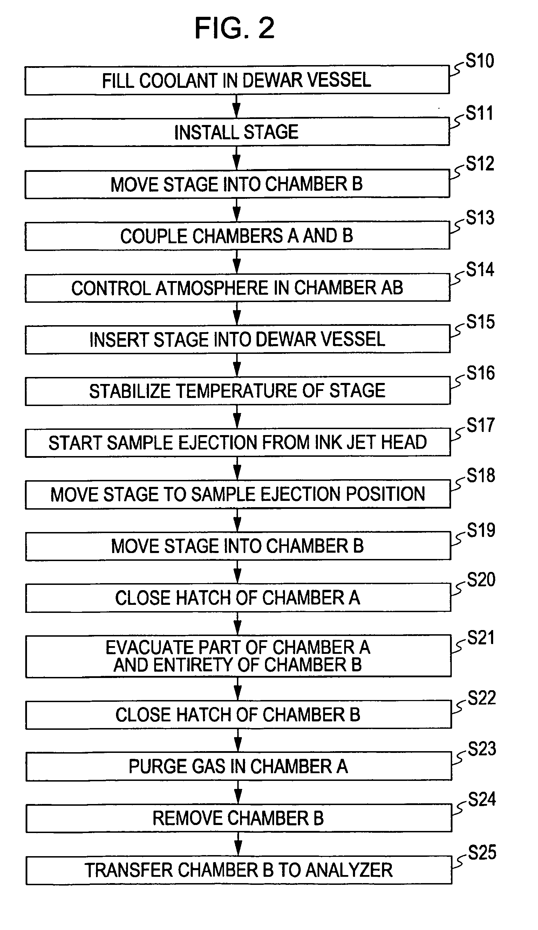

A sample fabricating method according to this exemplary embodiment of the present invention is described with reference to Fig. 2. Fig. 2 is a flowchart illustrating a sample fabricating procedure using the sample fabricating apparatus illustrated in Fig. 1.

While the following description, by way of an example, is based on the assumption that the temperature of the sample before the solidification is room temperature (about 20°C) and the stage temperature at the time of the solidification is the temperature of liquid nitrogen, the present invention is not limited to those temperatures. Also, while the following description, by way of example, refers to transferring the sample into a vacuum apparatus, the present invention is not limited thereto.

First, liquid nitrogen is filled in the Dewar vessel 6 installed inside the chamber A (step S10)

Then, the introduction rod 2a is mounted to the stage 1 (step S11).

The operating portion 2b is operated to move the stage 1 into the chamber B (step S12).

Then, the chamber B is moved such that the bottom opening of the chamber B is positioned to face a top opening of the chamber A, and the chamber B is coupled to the chamber A through the O-ring 3e (the coupled chambers are hereinafter referred to as a "chamber AB" (step S13).

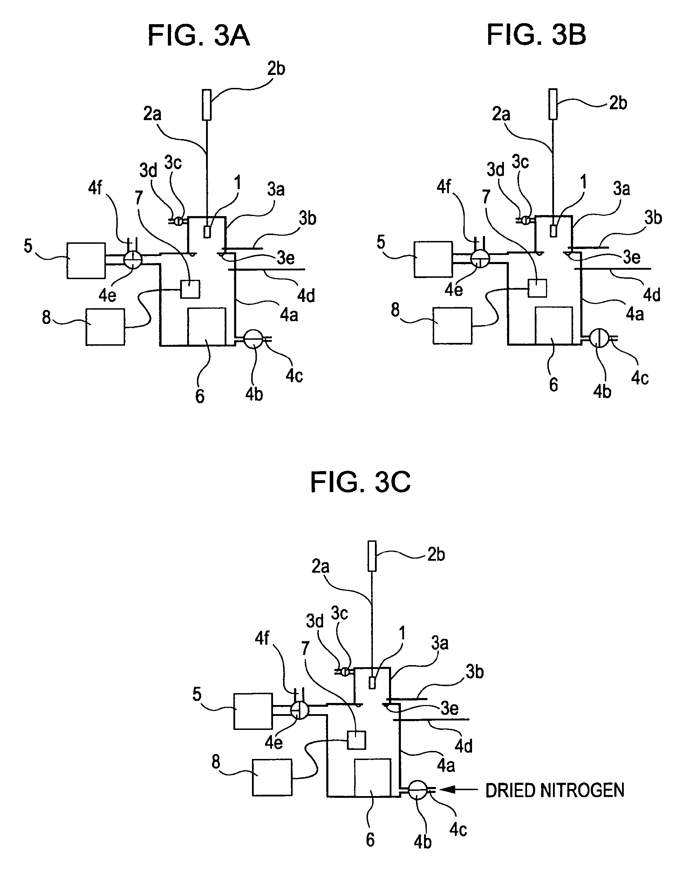

Fig. 3A illustrates the state where the above-described procedure is completed.

Then, the atmosphere inside the chamber AB is replaced with nitrogen (step S14).

The simplest nitrogen replacement procedure is performed by a method of opening both the purge gas opening/closing valves 3c and 4b and supplying dried nitrogen gas to flow into the chamber AB through either one of the purge gas introduction ports 3d and 4c.

An alternative method includes the steps of closing the purge gas opening/closing valves 3c and 4b, opening the selector valve 4e without connecting with the leak port 4f (Fig. 3B), and operating the vacuum pump 5 to remove the gas from the system. Thereafter, the selector valve 4e is closed without connecting with the chamber A (Fig. 3C), and dried nitrogen gas is supplied into the chamber through one of the purge gas introduction ports 3d and 4c. More preferably, the above-described evacuation and gas introduction are repeated.

When the liquid jet head is used as the sample ejection unit, it is possible for the ejection orifice of the liquid jet head to become clogged and for the meniscus to brake depending on an ambient environment where the head is placed, e.g., drying caused in the sample fabricating apparatus and the pressure of the atmosphere inside the sample fabricating apparatus, whereby the sample fails to eject. To avoid this problem, the ejection orifice of the liquid jet head is covered with a head cover (not shown), which can be operated externally of the chamber AB, until the time immediately before the sample is ejected as described below, so that the ejection orifice is shielded off from the ambient atmosphere (i.e., the atmosphere inside the sample fabricating apparatus). A unit for shielding the ejection orifice can be, e.g., a cap, a shutter, or a head cover.

Thus, the shielding unit can shield the ejection orifice of the head from a dried gas ambient atmosphere into which it is placed. More specifically, the step of shielding the specimen ejection orifice from the ambient atmosphere is performed at least during a period before or after the step of attaching the droplet to the stage surface.

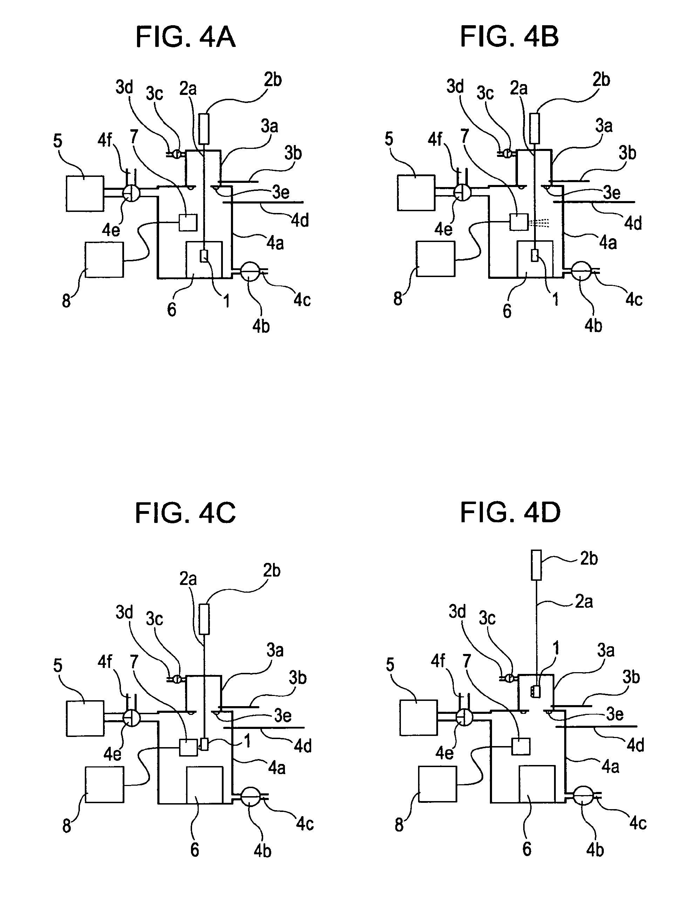

After the atmosphere in the chamber AB has been replaced with nitrogen, the operating portion 2b is operated to dip the stage 1 in the liquid nitrogen (not shown) filled in the Dewar vessel 6 (step S15), whereby the temperature of the stage 1 is stabilized to the temperature of the liquid nitrogen (step S16). The state in step S16 is illustrated in Fig. 4A.

Then, in the case of the ejection orifice of the head 7 being covered with a head cover (not shown), the head cover is removed and the ejection controller 8 is operated to successively eject sample droplets from the head 7 at a certain time interval (step S17). The state in step S17 is illustrated in Fig. 4B.

Then, the operating portion 2b is operated to lift up the stage 1 from the Dewar vessel 6 and to raise the stage 1 at a constant sped. The stage 1 is continuously raised at the constant speed even after reaching a sample ejection position (i.e., a position where the droplets are ejected) (step S18), thus causing the sample droplets to be successively attached to the stage 1. The state in step S18 is illustrated in Fig. 4C.

The attached sample is rapidly cooled by the stage 1 and is solidified.

Although the sample can be attached to a stationary stage 1, the sample is usually attached at a plurality of positions while moving the stage 1. In addition to ejecting the sample from one ejection orifice of the ink jet head 7, a plurality of heads can be arranged side by side in a direction perpendicular to the moving direction of the stage 1, so that the sample droplets are simultaneously ejected from the heads. Alternatively, a plurality of heads 7 can be arranged side by side in the moving direction of the stage 1 so that the droplets land at the same position on the stage 1 in an overlapping manner.

After the stage 1 has been moved out from the Dewar vessel 6, the temperature of the stage 1 gradually increases. The temperature of the entire stage 1 increases in the following manner. The temperature at the upper end of the stage 1 is higher than that at a lower end thereof because the upper end comes out from the Dewar vessel 6 at an earlier time. On the other hand, the sample droplet initially lands near the upper end of the stage 1, and the landing position gradually shifts toward the lower end of the stage as the stage is lifted up. Therefore, by setting the lifting speed of the stage 1 to match the rate at which the temperature thereof increases, the temperature at the position where each sample droplet lands can be made constant.

If the coolant evaporates and is being depleted during the above-described fabrication of the frozen sample, the position of the ink jet head of the ejecting apparatus is lowered in conformity with the surface level of the coolant, thus keeping constant the height from the surface level of the coolant to the ink jet head. As a result, the time from the departure of the stage 1 from the coolant surface to the landing of the droplet sample can be held constant.

After the attachment of the droplets has been completed as described above, the operating portion 2b is operated to move the stage 1 into the chamber B (step S19). The state in step S19 is illustrated in Fig. 4D.

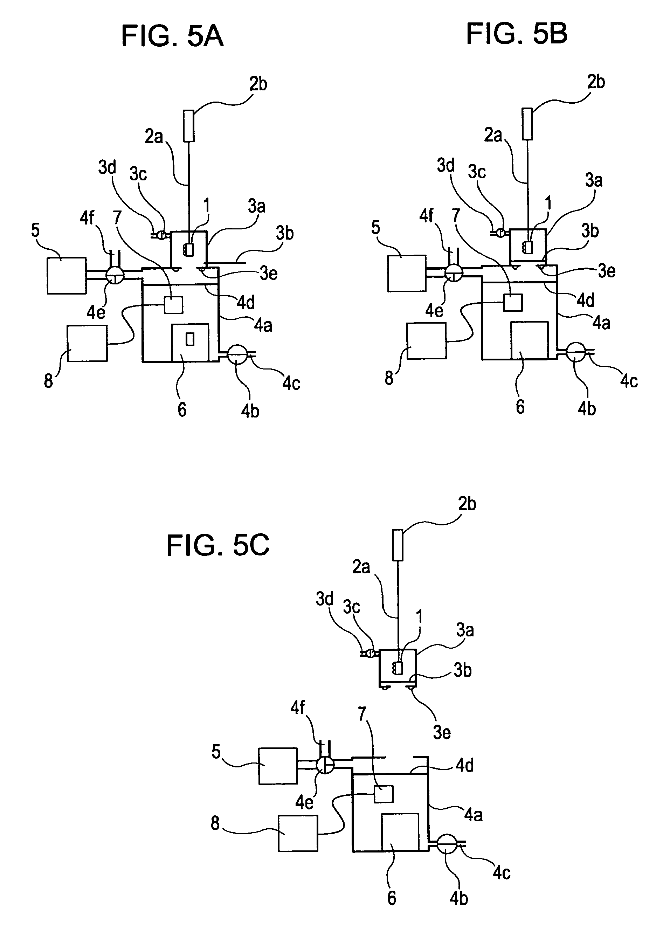

Then, the chamber hatch 4d of the chamber A is closed (step S20), and the selector valve 4e is shifted to the position where the chamber B and the vacuum pump 5 are connected to each other (i.e., the position illustrated in Fig. 5A). An upper space of the chamber A is then evacuated by the vacuum pump 5 (step S21). The state in step S21 is illustrated in Fig. 5A.

Since the sample attached to the stage 1 is cooled to a sufficiently low temperature, it is not lost during the evacuation process.

After the inner space of the chamber B has been sufficiently evacuated, the chamber hatch 3b is closed (step S22). The state in step S22 is illustrated in Fig. 5B.

Then, the selector valve 4e is shifted to the position where the chamber B and the leak port are connected to each other (i.e., the position illustrated in Fig. 5C), whereby the upper inner space of the chamber A is released to the atmospheric pressure (step S23). The chamber A and the chamber B are then separated from each other (step S24). The state in step S24 is illustrated in Fig. 5C.

Thereafter, the opening of the separated chamber B is connected to the vacuum apparatus (not shown) for observing the sample with the O-ring 3e interposed between them, and the chamber hatch 3b is opened. The operating portion 2b is operated to transfer the stage 1 into the vacuum apparatus (step S25), and the operating portion 2b is further operated to separate the stage 1 from the introduction rod 2a.

Further, after withdrawing the introduction rod 2a separated from the stage 1 and closing the chamber hatch 3b, the purge gas opening/closing valves 3c is operated to release the interior of the chamber B into the atmosphere, and the chamber B is removed from the vacuum apparatus.

Through the above-described steps, the sample in the solidified state is prepared in a machining/observing station (i.e., a station including a machining mechanism and an observing mechanism).

The machining mechanism includes the above-described FIB machining apparatus, which can machine the sample in a vacuum to form a cross-section. The observing mechanism includes the SEM apparatus. As an alternative, the sample surface can also be directly observed by the SEM apparatus without performing the FIB machining.

### Second Exemplary Embodiment

### Sample Observing Apparatus 1

A sample observing apparatus according to a second exemplary embodiment is described below. The sample observing apparatus is an apparatus in which a sample fabricating apparatus and a cross-section machining and observing apparatus are integrally combined with each other.

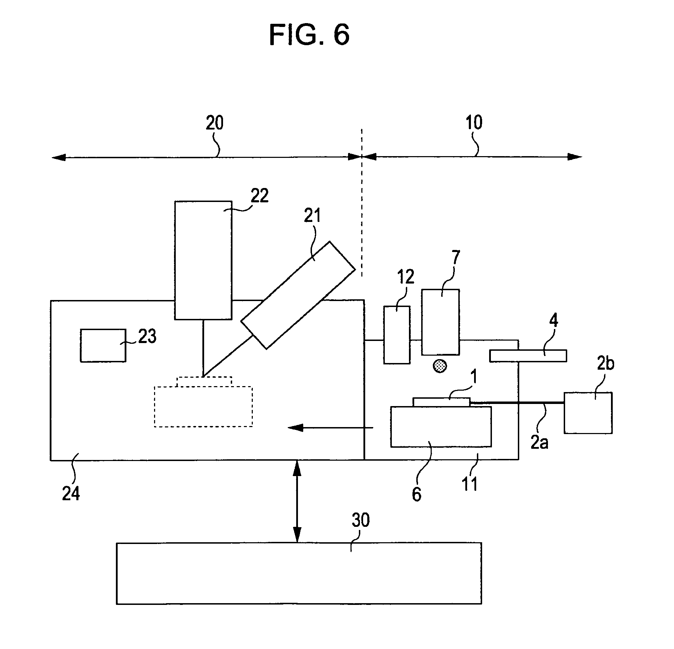

Fig. 6 illustrates a construction of an FIB-SEM apparatus for observing the cross-section, which includes the sample fabricating apparatus, according to this exemplary embodiment. The FIB-SEM apparatus of Fig. 6 is constituted by a sample fabricating section 10, a machining and observing section 20, and a control section 30. The second exemplary embodiment differs from the first exemplary embodiment in that the sample fabricating section is added as a pre-processing chamber for the FIB-SEM apparatus.

As in the sample fabricating apparatus of Fig. 1, the sample fabricating section 10 includes a movable stage 1 on which a sample is placed, a stepping motor 2b as a moving mechanism, a coupling rod 2a for coupling the stepping motor 2b to the sample, a cooler 6, and a droplet ejecting apparatus 7. Further, the sample fabricating section 10 includes a gas introducing unit 4 associated with a gas inlet port and an opening/closing valve, through which nitrogen gas for purging is introduced.

While the apparatus of Fig. 1 has two separable chambers, the apparatus of Fig. 6 has one integral pre-processing chamber 11 in which the stage 1 and the droplet ejecting apparatus 7 are both installed.

The stage 1 is held in contact with the cooler 6 made of a Peltier device and is slidable with respect to the cooler 6.

The droplet ejecting apparatus (specimen supply unit) 7 is constituted by a liquid jet head as in the apparatus of Fig. 1.

The machining and observing section 20 is constituted by an FIB apparatus 21, an SEM apparatus 22, and a reflected electron detector 23 for detecting electrons reflected or emitted from a sample. Further, the sample stage 1 is moved from the pre-processing chamber 11 into the machining and observing section 20 to be positioned therein for FIB machining and SEM observation. An area where the stage is placed is included in a chamber 24, so that the FIB machining and the SEM observation are performed in a vacuum.

### Sample Observing Method 1

For example, a liquid sample (AB) is prepared, as a specimen, which is obtained by dispersing drug-containing microcapsules, i.e., a dispersive substance (B), in a solution (A) serving as a dispersion medium. The prepared liquid sample (AB) is contained in a liquid container of the liquid jet head 7, which constitutes the specimen supply unit.

After depressurizing the pre-processing chamber 11 by a pump (not shown), dried nitrogen gas is introduced through the gas introducing unit 4 to provide a dry atmosphere in the pre-processing chamber 11. That operation is repeated several times, as required, until the atmosphere in the pre-processing chamber 11 is sufficiently replaced with the dried nitrogen gas.

The setting temperature of the cooler 6 is selected to be, for example, in the range of -140°C to - 170°C, and it is confirmed that the stage has reached that temperature. In this state, the stage 1 is operated to slide at a constant speed by the stepping motor 2b, and at the same time, a droplet of 1 pl to 100 pl is ejected from the ink jet (IJ) head 7. For example, the distance between the stage 1 and the IJ head 7 is set to be in the range of 0.1 mm to 10 mm, and the flying speed of the droplet is set to be in the range of 1 m/sec to 100 m/sec. In such a manner, dots of a solid sample in the form of the frozen droplets are formed on the stage 1 at a certain interval. The distance through which the stage 1 is moved is smaller than the size of the cooler 6, and the temperature of the stage 1 is held constant irrespective of the position on the stage 1.

Next, to prevent charge accumulation on the sample during the SEM observation and the FIB machining, a metal film is coated over the surface of the solid sample, including the stage 1 on which the solid sample is formed. To that end, the head 7 is capped and the stage 1 is moved to a position just under a metal film coating unit 12. After sufficiently evacuating the pre-processing chamber 11 by the pump (not shown), the valve in the gas introducing unit 4 is adjusted to regulate the pressure in the pre-processing chamber 11 and to maintain it, for example, in the range of 10 Pa to 1 Pa. In such a state, the metal film coating unit 12 is operated to sputter gold particles to thereby form a gold coating film over the solid sample on the stage 1. At that time, the discharge current is set to be in the range of about 1 mA to 100 mA, and the sputtering time is adjusted so as to form the gold coating film with a thickness in the range of about 2 nm to 10 nm.

After forming the gold coating film, the pre-processing chamber 11 is sufficiently evacuated while keeping the temperature of the stage 1 in the range of - 140°C to -170°C. Then, a door (not shown) between the pre-processing chamber 11 and the chamber 24, which includes the FIB-SEM apparatus, is opened and the stage 1 is introduced into the chamber 24 together with the cooler 6.

Even after being moved into the chamber 24, the stage 1 is held at the above-mentioned temperature by the cooler 6. While maintaining that state, a cross-section evaluation of the microcapsules fixed at the low temperature is conducted in accordance with the following procedure.

First, the SEM observation of the sample surface is performed by the SEM apparatus 22, and a substantially central portion of the sample is determined as a cross-section observation area based on a resulting SEM image. The determined cross-section observation area is irradiated and scanned with a very weak ion beam by the FIB machining apparatus 21 to obtain an image of emitted secondary ions (i.e., an SIM (Scanning Ion Microscope) image). At that time, a gallium ion source can be used as an ion beam source, and irradiation conditions can be set such that the acceleration voltage is in the range of 5 kV to 100 kV, the beam current is in the range of 1 pA to 100 pA, and the beam diameter is in the range of 1 nm to 50 nm. A precise cross-section machining position is determined from the obtained secondary ion image.

Then, rough-machining of the sample is performed at the determined cross-section machining position by the FIB machining apparatus 21. For example, a rectangular recess having a 10 µm to 100 µm square part is formed in the sample surface to a depth of 10 µm to 50 µm using the ion acceleration voltage of 5 kV to 100 kV, the beam current of 10 nA to 1000 nA, and the beam diameter of about 10 nm to 500 nm. The rough machining proceeds under weak conditions, and the machined cross-section is observed in certain steps, as required, by the SEM apparatus 22 to confirm that the machining is performed at the desired position.

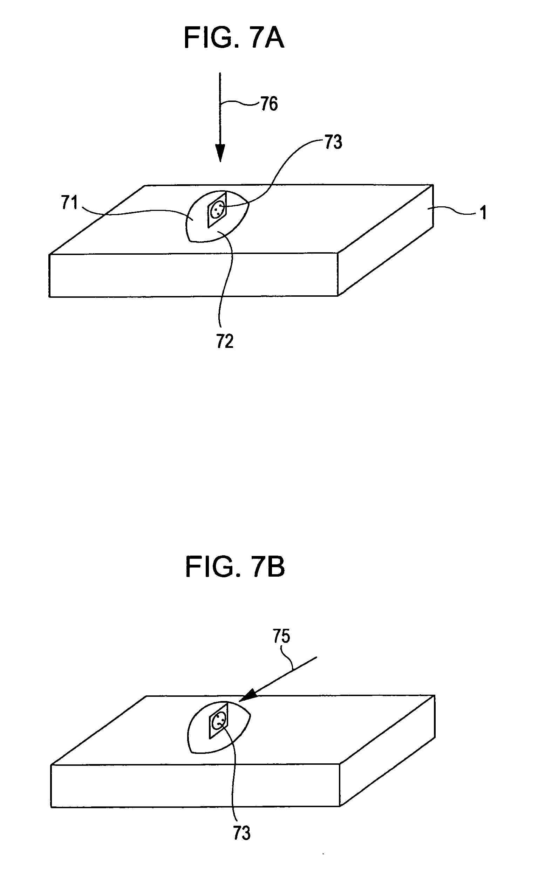

Fig. 7A illustrates the cross-section formed by the FIB machining. A rectangular recess 72 is machined substantially at the center of a solidified sample 71 by the ion beam 76, and a vertical cross-section 73 is formed with respect to the stage 1.

When the machining is substantially completed, the irradiation of the ion beam from the FIB machining apparatus 21 is stopped, and the SEM observation of the cross-section is performed by selecting the electron beam from the SEM apparatus 22. In conducting the observation, the electron beam is irradiated at an angle of about 40° to 70° with respect to the machined cross-section and is scanned over the cross-section. This observation can confirm the presence of microcapsules of about 10 µm to 40 µm in the machined cross-section.

The ion beam from the FIB machining apparatus 21 is selected again to finish the machining process. To increase the machining accuracy, this ion beam is thinner than that used in the rough machining under weak conditions compared to those in the case of the SIM observation, thereby machining the cross-section including the microcapsules.

Finally, the SEM observation of the sample cross-section thus fabricated is performed by using the SEM apparatus 22.

Fig. 7B illustrates the irradiation of the electron beam in the SEM observation. The SEM observation is performed by irradiating an electron beam 75 to the vertical cross-section 73 of the solidified sample 71 at an angle in the range of about 40° to 70° and scanning the electron beam 75 over the cross-section.

The state of the microencapsulated drugs can be confirmed from an obtained SEM image. Also, the dispersion state of the microcapsules can be clearly observed.

In the observation method of this exemplary embodiment, as described above, since the FIB machining is performed while the solid sample is maintained at the low temperature, the cross-section maintaining the dispersion state of the droplet can be formed without causing a significant change, e.g., deformation of the region of the drug corresponding to the substance (B), during the machining. Further, since the SEM observation can be performed in the same apparatus as used for the sample fabrication, the desired temperature can be easily maintained.

### Third Exemplary Embodiment

### Sample Observing Apparatus 2

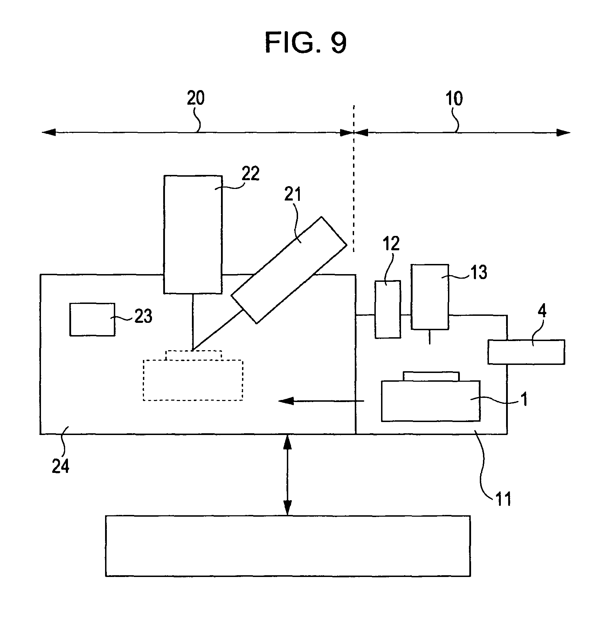

Fig. 9 illustrates the structure of a sample observing apparatus according to a third exemplary embodiment. In the apparatus of Fig. 9, instead of the liquid jet head, a specimen supply unit 13 having a hollow tube disposed at its bottom end is disposed as the specimen supply unit in the pre-processing chamber 11. The other components are the same as those in the sample observing apparatus of Fig. 6.

A liquid sample held as a specimen in the hollow tube is pressurized by a pressurizing apparatus (not shown) and is ejected through an ejection orifice formed at a distal end of the hollow tube. The ejected sample flies in the form of a droplet and is attached to the stage surface.

### Fourth Exemplary Embodiment

### Sample Observing Apparatus 3

A sample observing apparatus according to a fourth exemplary embodiment is provided by adding an image processing section to the apparatus for performing the sample fabrication, the FIB machining, and the SEM observation.

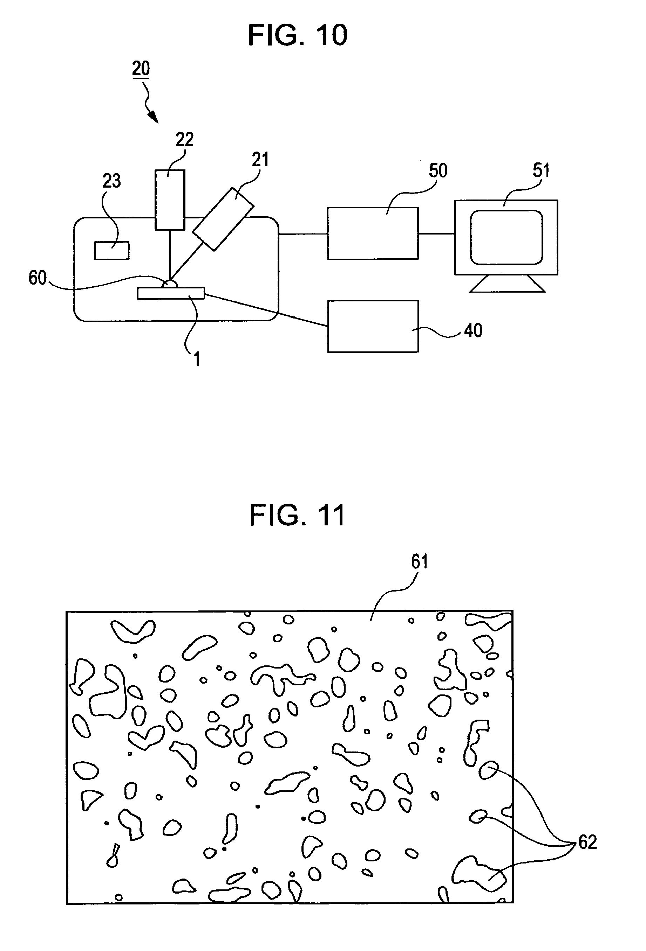

Fig. 10 schematically illustrates the structure of the sample observing apparatus according to the fourth exemplary embodiment. The sample observing apparatus of this exemplary embodiment includes a stage 1, a machining and observing section 20, a cryo-system control section 40, a control section 50 for the FIB-SEM apparatus, and an image processing section 51 connected to the control section 50.

The stage 1 is a stage capable of cooling a sample and controlling the temperature of the sample to a desired low level. The machining and observing section 20 is formed by integrating an FIB machining apparatus 21 and an SEM apparatus 22 into one unit. The stage 1 is associated with the cryo-system control section 40 for keeping the stage 1 at a low temperature.

The image processing section 51 executes an edge emphasizing process of detecting the contour of the dispersed substance from an obtained image so as to emphasize the contour. An edge-emphasized SEM image is thus formed.

### Sample Observing Method 2

As a liquid sample (AB), an aqueous disperse solution is prepared in which particles having a mean particle diameter of 50 nm to 500 nm are dispersed as a dispersive substance (B) with a contained disperse-particle concentration ranging from 1 vol% to 30 vol%. The liquid sample is ejected from a liquid jet head to fly in the form of a droplet and is attached to the cooled stage, whereby the droplet sample is frozen to form an amorphous solid. Further, for an electro-conduction process, platinum is vapor-deposited on the sample with a film thickness of about 10 nm to 50 nm by ion sputtering. Thereafter, the chamber B is separated and moved such that the stage 1 including a solid sample 60 placed thereon is installed in the apparatus of Fig. 10.

A cross-section is formed in the sample by the FIB machining apparatus 21 while the stage temperature is kept low by the cryo-system control section 40. After performing rough machining by setting the beam current in the FIB machining apparatus 21 to the range of 200 pA to 400 pA, machining is finished by setting the beam current in the range of 30 pA to 150 pA.

An SEM image is obtained from an output of the reflected electron detector 23.

Image processing, such as an edge emphasizing process, is executed on the obtained SEM image of the cross-section by the image processing section 51 to form an image in which the particle contours are emphasized.

### Sample Observing Method 3

With Sample Observing Method 3, an aqueous disperse solution containing different types of plural particles can be observed with the SEM. Stated another way, in an aqueous liquid containing two or more types of dispersed particles, which cannot be discriminated from each other based on their shapes, the states of the respective particles can be confirmed.

A sample prepared in the same manner as in Sample Observing Method 1 is machined to form a cross-section. An energy dispersion fluorescence/X-ray spectrometer (EDX apparatus) is mounted to the machining and observing section 20 instead of the reflected electron detector 23, and a cross-sectional image is obtained from an output of the EDX apparatus.

Thus, by adding the EDX apparatus to the sample fabricating, machining and observing apparatus, it is possible, based on the obtained image, to measure dispersivity for each of the different types of particles and to observe aggregation and dispersion of the particles. Further, a particle size distribution per particle type can be determined.

### Sample Observing Method 4

The contours of dispersed substances, such as micro-particles in a liquid, often become unclear even in trying to recognize them in an SEM image, depending on the type of the liquid sample and the dispersive substance. Therefore, there is sometimes a need for a clearer image. The edge emphasizing process is considered to be image processing and it cannot be deemed sufficient from the viewpoint of preciseness in the observation.

Sample Observing Method 4 is intended to overcome this problem.

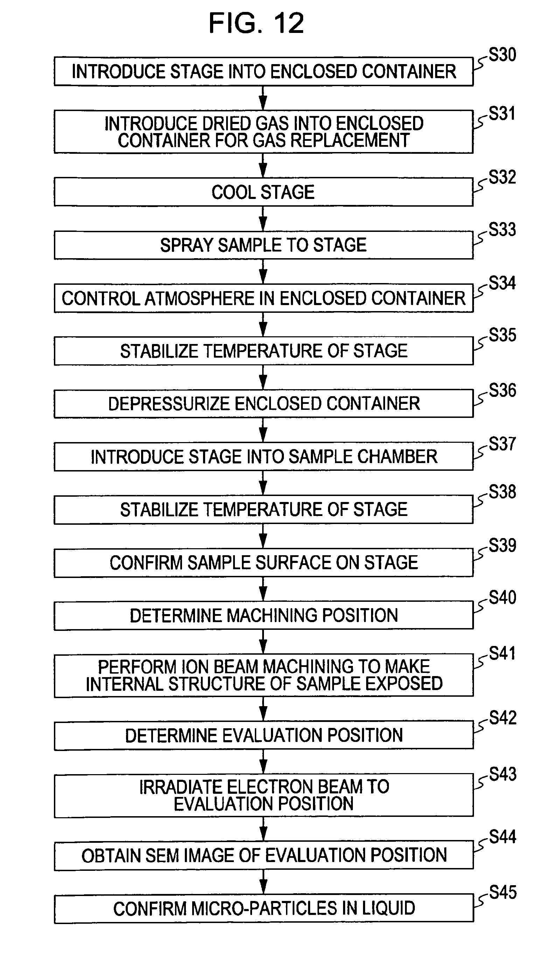

Fig. 12 is a flowchart illustrating an example of Sample Observing Method 4. An apparatus used herein is the same as that illustrated in Fig. 6.

The term "cross-section" used herein refers not only to a section of the surface taken along a certain plane inside the sample, but also to a surface observable from a certain viewing point after machining or processing (including deposition and etching) when the sample is subjected to the machining.

First, the stage 1 is introduced to the enclosed container (pre-processing chamber) 11 (step S30). Then, dried gas is introduced to the enclosed container 11 through the gas introducing unit 4 for gas replacement in the enclosed container 11 (step S31). At that time, the dried gas is introduced after depressurizing the enclosed container 11 by a pump (not shown), thus suppressing the influence of the residual gas. For example, dried nitrogen gas can be used as the dried gas.

Then, the stage 1 is cooled by the cooler 6 under temperature control with the control section 30 (step S32).

The temperature of the stage 1 is set as described above.

Then, a liquid is ejected from the liquid jet head 7 to the stage 1, which is sufficiently cooled by the cooler 6, thereby forming a droplet (step S33). By adjusting the viscosity, the flying speed, the volume and the flying distance traversed by the droplet to respective predetermined values, the droplet that lands on the stage 1 forms a uniform thin film and a region of the droplet to be observed can be converted into the amorphous state in its entirety.

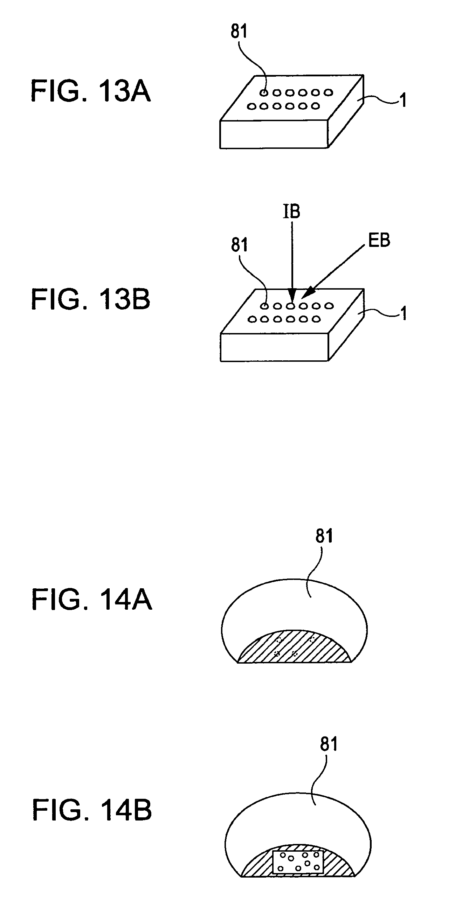

Fig. 13A illustrates a plurality of mutually spaced droplets 81 fixed on the stage 1. The temperature and the position of the stage 1 can be controlled by the control section 30. Also, the volume and the flying speed of each droplet 81 can be controlled by the head 7. Accordingly, the required volume of the droplet 81 can be fixated at a desired position on the stage 1 with a high level of accuracy.

Further, when the droplet 81 is cooled, it is advantageous for the cooling rate to be set at 40°C/min or more.

The atmosphere in the enclosed container 11 is replaced with a dried gas atmosphere to prevent dew condensation of the sufficiently cooled stage 1 (step S34).

After confirming that the temperature of the droplet 81, which has been rapidly solidified on the stage 1, and the temperature of the stage 1 stabilized (step S35), the enclosed container 11 is depressurized by the pump (not shown) (step S36).

The stage 1, which has been sufficiently cooled and includes the solidified droplet fixed thereon, is introduced to the sample chamber 24 of the machining and observing apparatus, which has been depressurized in advance (step S37)

Fig. 13B illustrates one example of the droplets 81 which have been fixed on the stage 1 introduced to the sample chamber 24. The droplets 81 can be observed or machined by an electron beam EB from the SEM apparatus 21 and a focused ion beam IB from the FIB machining apparatus 22, which are both disposed in the sample chamber 24.

After confirming that the temperature of the stage 1 stabilized (step S38), the surface of the sample droplet 81 on the stage 1 is confirmed by the SEM apparatus 21 (step S39), and the focused ion beam is scanned by the FIB machining apparatus 22 to determine a machining position (step S40).

Then, the sample is machined by the FIB machining apparatus 22. The ion beam from the FIB machining apparatus 22 hits the stage 1 substantially perpendicularly, and the electron beam from the SEM apparatus 21 is arranged to hit the sample at an angle of several tens of degrees with respect to the ion beam. With such an arrangement, a vertical cross-section (primary machined surface) perpendicular to the surface of the stage 1 can be exposed and formed at a desired position of the sample 81 (step S41).

The internal structure of the sample that is being machined can be observed by obtaining a cross-section image with the electron beam from the SEM apparatus 21, which is arranged at an angle of several tens of degrees with respect to the FIB machining apparatus 22. In other words, SEM observation of the exposed cross-section at a low magnification can be used to determine whether the cross-section of the sample has been sufficiently machined. The ion beam for the machining often deviates from the machining position. In such a case, the machining position can be corrected by confirming it with the SEM apparatus 21.

For the ion beam used for the machining, machining energy can be adjusted depending on the size (breadth) and the depth of the exposed cross-section. Further, the energy of the machining beam can be adjusted such that the sample is initially machined by the beam having a relatively large energy, and the beam energy is then reduced step by step as the evaluation position is approached. At that point, the machined surface can be observed by the SEM apparatus 21.

Thus, the internal structure is exposed and the evaluation position is determined while confirming the machined cross-section by the SEM apparatus 21 (step S42).

Fig. 14A illustrates one example of an SEM image of the machined cross-section of the sample 81, which has been exposed by the above-described method. Typically, micro-particles dispersed in the sample 81 are hard to recognize immediately after machining. For that reason, the evaluation position is screened and determined by finding a position free from the so-called defects, such as bubbles and track lines of the machining beam generated during the machining, while confirming the cross-section SEM image. Thereafter, the newly determined evaluation position is slightly irradiated by the electron beam, thus providing a secondary machined surface (step S43).

With the slight irradiation of the electron beam, the solidified body of the liquid (A), i.e., one component of the sample, can be sublimated to some extent on the sample surface irradiated by the electron beam. This means that a part of the solidified body of the liquid (A) around the substance (B) is removed while maintaining the dispersion state of the substance (B) in the sample. Therefore, the contours of the substance (B), such as micro-particles, can be made clearer on the surface to be observed and the observation can be facilitated.

When irradiating the electron beam for sublimating the liquid, the electron beam is scanned at a high rate of speed over an area in the cross-section, which is a little larger than a spot area of the evaluation position. By scanning the electron beam in this manner, the spot area of the evaluation position can be uniformly irradiated in its entirety even when the electron beam fluctuates to some extent. Furthermore, excessive irradiation of the electron beam can be prevented and the solidified body of the liquid (A) can be sublimated while maintaining the dispersion state of the substance (B).

In addition, the acceleration voltage of the electron beam for sublimating the liquid can be set at 100 V to 30 kV. By setting the acceleration voltage in this range, the solidified body of the liquid in the sample surface irradiated with the electron beam can be sublimated appropriately and control can be maintained more easily from the operating point of view.

The irradiation time of the electron beam is appropriately determined depending on the irradiation area, the scanning speed and the acceleration voltage of the electron beam, as well as the type of the medium of the liquid sample. It can be selected from a range allowing the solidified sample around the micro-particles to be appropriately removed while maintaining the dispersion state of the micro-particles in the solidified body of the liquid.

After scanning the electron beam over the evaluation position for a certain period of time in this manner, an SEM image of the evaluation position is obtained (step S44).

Fig. 14B illustrates one example of the SEM image of the exposed cross-section after irradiating the electron beam for the sublimation. In comparison with Fig. 14A, the contours of the micro-particles present in the dispersion medium, which was originally in liquid form, are made clearer and the dispersion state can be more easily evaluated. As a result of irradiating the electron beam, the solidified body of the liquid in the exposed cross-section is sublimated and removed to some extent, and the cross-section of the solidified dispersion medium is slightly moved rearwards of the machined cross-section, i.e., toward the more internal side with respect to the machined cross-section. Accordingly, the micro-particles in the remaining solidified body in the dispersion medium are exposed while maintaining their positions, whereby the contours of the micro-particles are more clarified and a sharper SEM image can be obtained.

By obtaining the SEM image in such a manner, the positions of the micro-particles, i.e., the substance (B), in the dispersion medium, i.e., the liquid (A), can be precisely evaluated (step S45).

Particularly, when the micro-particles (B) that have diameters on a nanometer scale are dispersed in the liquid (A), the temperature of the entire sample 81 is increased when the temperature of the stage 1 on which the droplet is fixed at a low temperature is increased. Hence, it is possible that when the temperature of the sample 81 reaches the sublimation temperature of the liquid (A), the solidified body of the dispersion medium will sublimate and the dispersion state of the micro-particles could no longer be observed.

With this sample observing method, however, since the evaluation position is initially slightly irradiated with the electron beam, only the dispersion medium in the irradiated region can be selectively sublimated. Also, since the observation can be performed while maintaining the dispersion state of the micro-particles, the microstructure of the dispersion state can be precisely evaluated.

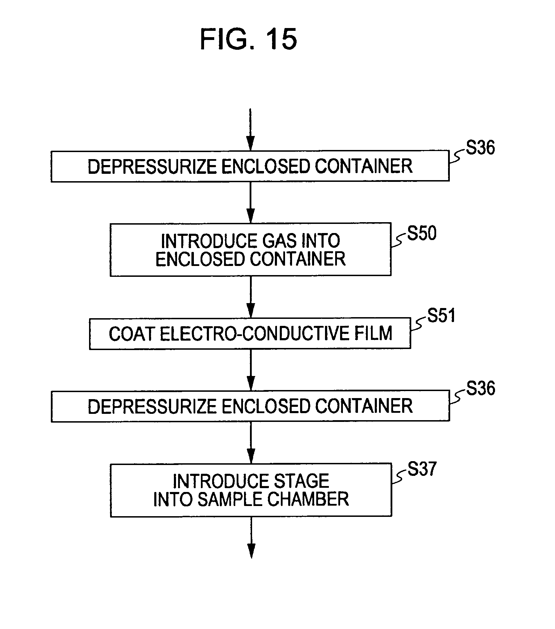

Further, this exemplary embodiment can be modified so as to add a process of coating the sample with an electro-conductive material. This is particularly effective when the sample has low electro-conductivity, like an insulating material. Fig. 15 illustrates a part of the electro-conductive film coating process.

As described above, the electro-conductive material can be coated over the sample 81, e.g., by sputtering of a metal film. In that case, the electro-conductive material (metal film) coating unit 12 can be formed by a metal film target, an electrode and a power supply for the sputtering, etc.

The enclosed container 11 is depressurized by the pump (not shown) (step S36). Then, dried inert gas, e.g., argon, is introduced (step S50) and RF power is supplied to the target (cathode) to generate an RF plasma atmosphere. As a result, the target is sputtered by the argon plasma and the metal film is deposited on the stage 1 including the sample 81 (step S51). Thereafter, the enclosed container 11 is depressurized again by the pump (not shown) (step S36), and the stage 1 including the metal film coated thereon is introduced into the sample chamber 24 (step S37). The metal film can also be coated by CVD or vacuum vapor deposition.

### EXAMPLE 1

In EXAMPLE 1, microcapsules containing drugs (trade name: "Leuplin Injection Kit 1.88", a powder and suspension kit made by Takeda Chemical Industries, LTD.) were prepared as the liquid sample.

The process of fabricating a solid sample, machining the solid sample to form a cross-section, and observing the cross-section was performed in accordance with the following procedure by using the apparatus of Fig. 6.

After depressurizing the pre-processing chamber 11, dried nitrogen gas was introduced to make dry an atmosphere in the pre-processing chamber 11. That operation was repeated several times until the atmosphere in the pre-processing chamber 11 was sufficiently replaced with the dried nitrogen gas.

The temperature of the cooler 6 was set to -140°C, and the cooling of the stage to this temperature was confirmed by using the temperature sensor. In this state, the stage 1 was moved at a constant speed. At the same time, a 10 pl droplet was ejected from the head 7. The distance between the stage 1 and the IJ head 7 was set to 2 mm, and the flying speed of the droplet was set to 70 m/sec. In such a manner, dots of a solid sample in the form of frozen droplets were formed on the stage 1 spaced apart by a certain interval.

The head 7 was capped to shield the ejection orifice from the atmosphere in the pre-processing chamber 11. The stage 1 was moved to a position just under the metal film coating unit 12. After sufficiently evacuating the pre-processing chamber 11 by the pump (not shown), the valve in the gas introducing unit 4 was adjusted to regulate the pressure in the pre-processing chamber 11 and to hold it at 6 Pa. In such a state, the metal film coating unit 12 was operated to sputter gold, whereby a gold coating film was formed over the solid sample on the stage. At that time, the discharge current was set to 15 mA, and the sputtering time was adjusted to form the gold coating film with a thickness of about 5 nm.

After forming the gold coating film, the pre-processing chamber 11 was sufficiently evacuated while holding the temperature of the stage 1 at -140°C. Then, the door (not shown) between the pre-processing chamber 11 and the chamber 24, including the FIB-SEM apparatus, was opened and the stage 1 was introduced to the chamber 24 together with the cooler 6.

Even after being moved into the chamber 24, the stage 1 was held at about -140°C by the cooler 6. While maintaining that state, a cross-section evaluation of the microcapsules fixed at the low temperature was executed in accordance with the following procedure.

First, the SEM observation of the sample surface was performed by the SEM apparatus 22, and a substantially central portion of the sample was determined as a cross-section observation area based on a resulting SEM image. A very weak ion beam for observation was irradiated to and scanned over the determined cross-section observation area by the FIB machining apparatus 21 to obtain an image of the emitted secondary ions (i.e., an SIM (Scanning Ion Microscope) image). At that time, a gallium ion source was used as the ion beam source, and irradiation conditions were set to the acceleration voltage of 30 kV, the beam current of 20 pA, and the beam diameter of about 30 nm. A precise cross-section machining position was determined from the obtained secondary ion image.

Then, rough-machining of the sample was performed at the determined cross-section machining position by the FIB machining apparatus 21. More specifically, a rectangular recess having a 50 µm square part and a depth of 30 µm was formed in the sample surface with the ion acceleration voltage of 30 kV, the beam current of 100 nA, and the beam diameter of about 300 nm. The rough machining was performed under weak conditions, and the cross-section being machined was observed at certain points by the SEM apparatus 22 to confirm that the machining was performed at the desired position.

Fig. 7A illustrates the cross-section formed by the FIB machining. It was confirmed that a rectangular recess 72 was machined substantially at the center of the solidified sample 71 by the irradiation of the ion beam, and a vertical cross-section 73 was formed with respect to the stage 1.

When the machining was substantially completed, the irradiation of the ion beam from the FIB machining apparatus 21 was stopped, and the SEM observation of the cross-section was performed by selecting the electron beam from the SEM apparatus 22. In the observation, the electron beam was irradiated at an angle of about 60° with respect to the machined cross-section and was scanned over the cross-section. The presence of the microcapsules of about 20 µm in the machined cross-section could be confirmed by the observation.

The ion beam from the FIB machining apparatus 21 was selected again to finish the machining. To increase machining accuracy, that ion beam was thinner than the one used in the rough machining process under weak conditions comparable to those in the case of the SIM observation, thereby machining the cross-section including the microcapsules.

Finally, the SEM observation of the sample cross-section thus fabricated was performed by using the SEM apparatus 22.

Fig. 7B illustrates irradiation of the electron beam in the SEM observation. The SEM observation was performed by irradiating the vertical cross-section 73 of the solidified sample 71 with the electron beam 75 at an angle of 60° and scanning the electron beam 75 over the cross-section. The SEM observation conditions were set to the acceleration voltage of 800 V and a magnification of 50,000 times for photographing.

The state of supports and drugs in the microcapsules could be confirmed from an obtained SEM image. Also, the dispersion state of the microcapsules could be clearly observed.

Thus, according to EXAMPLE 1, as in the second exemplary embodiment, since the FIB processing was performed while the sample temperature was maintained at the low level (-140°C), the cross-section maintaining the dispersion state of the droplet could be formed without causing a significant change, e.g., deformation of a drug layer, during the machining process. Further, since the SEM observation was performed in the same apparatus as that used for sample fabrication, the desired temperature could be easily maintained.

### EXAMPLE 2

In EXAMPLE 2, a sample was prepared by coating a sliver paste, as a liquid material, on a glass substrate by using a dispenser, and a cross-section evaluation was performed on the sample after solidifying it. An apparatus used herein was the same as that illustrated in Fig. 6, except for employing a dispenser instead of the liquid jet head 7. The stage setting temperature was selected as - 100°C.

A very small amount of a sliver paste (composition of silver particles, resin, and a solvent) was propelled out from the dispenser and was dropped onto the stage 1 from a certain height. The silver paste was thereby solidified in a short period of time. By repeating the above step, a silver paste pattern was formed on the stage 1.

Before the FIB machining, to prevent charge build-up, a platinum film with a thickness of 30 nm was formed on the sample surface by ion beam sputtering. The other steps until the finish of the machining were executed under the same conditions as those in EXAMPLE 1.

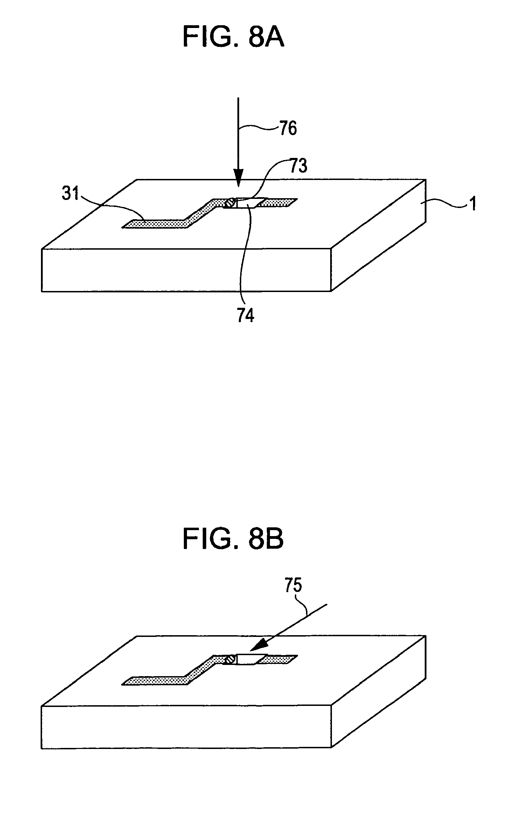

Fig. 8A illustrates a sample having a cross-section formed by the FIB machining. A rectangular recess 74 was formed in a part of a silver paste pattern 31 with the irradiation of an ion beam 76, and a vertical cross-section 73 of the silver paste was exposed.

The stage 1 was inclined and an SEM image was observed by obliquely irradiating an electron beam 75 to the vertical cross-section 73 of the silver paste, as shown in Fig. 8B. The silver paste pattern 31 was in close contact with the stage 1, and the dispersion state of the solvent and the silver paste dispersed in the medium immediately after printing could be evaluated. The observation conditions at that time were set to the acceleration voltage of 15 kV and a magnification of 30,000.

### EXAMPLE 3

In EXAMPLE 3, by using the apparatus of Fig. 9, a sample was fabricated through the steps of ejecting, from the hollow tube, an emulsion cream (trade name: "SK-II Facial Treatment Concentrate", made by MAXFACTOR) to be attached to the cooled stage, and cooling the attached cream for solidification.

After replacing the atmosphere in the pre-processing chamber 11 with nitrogen gas and cooling the stage 1, the emulsion cream (not shown) was dripped onto the stage 1 from an ejection orifice at the distal end of the hollow tube for solidification of the sample. Then, gold was coated over the sample by sputtering to prevent charge build-up.

As a result of observing a sample cross-section, the cross-section of the emulsion cream could be observed. Specifically, the dispersion state of the dispersive substance (B) in the liquid component (A) in the emulsion cream could be clearly observed.

### EXAMPLE 4

In EXAMPLE 4, a sample was observed by using the apparatus of Fig. 10.

For a liquid sample (containing a graphite carbon pigment dispersed in water) to be observed in EXAMPLE 4, it was known from an optical measurement that particles with the mean particle diameter of 150 nm were dispersed. An aqueous dispersed solution that contained dispersed particles at a concentration of 10 vol% was frozen and fixated in the same manner as that in EXAMPLE 1. Further, platinum was vapor-deposited over the sample with a film thickness of 30 nm by ion beam sputtering.

A sample cross-section was exposed by the FIB machining apparatus 21 while the temperature of the temperature-adjustable stage was held at -140°C or less by the cryo-system control section 8. After performing rough machining by using a gallium ion beam as the FIB with the acceleration voltage and the beam current set to 30 kV and 300 pA, respectively, machining was finished at the acceleration voltage of 30 kV and the beam current of 100 pA.

An SEM image was obtained from an output of the reflected electron detector 23 under the conditions of the acceleration voltage of 1.5 kV and the beam current of 10 pA.

Fig. 11 shows the result obtained by extracting the contours of the particles from the SEM image of the cross-section with the image processing section 51. It was confirmed that dispersive substances 62 were dispersed in a medium 61.

More specifically, it was confirmed from Fig. 11 that the sample used in this measurement contained not only particles having diameters of 100 nm and 200 nm, but also larger-sized particles having diameters of about 300 nm, and that the sample had good dispersibility and contained many particles present in a primary particle state.

On the obtained SEM image, a slight machining streak appeared in the cross-section due to beam damage caused on the sample surface. As a result of irradiating the electron beam for the observation, it was confirmed that only the medium was gradually sublimated and removed from the solid sample, and the machining streak disappeared.

### EXAMPLE 5

In EXAMPLE 5, the apparatus illustrated in Fig. 6 was employed. Also, a water-soluble pigment ink with a colorant made of copper phthalocyanine dispersed therein was prepared as a specimen.

First, a silicon substrate having a surface that was treated to be hydrophilic was fixed, as the temperature-controllable stage 1, on a copper-made base by using a carbon paste. Then, the stage 1 was introduced into the enclosed container (pre-processing chamber) 11 and dry nitrogen was introduced into the enclosed container 11.

The setting temperature was selected to be -150°C, and it was confirmed that the stage 1 was held at the selected evaluation temperature. Droplets of the ink, i.e., the sample, were ejected from the head 7 toward 10 positions on the stage 1. When ejecting the droplets, the stage position was adjusted so as to provide the droplet size with a diameter of about 20 µm and the flying speed of about 10 m/sec.

After depressurizing the enclosed container 11 by the pump, the stage 1 was introduced into the sample chamber 24 and the height of the stage 1 was adjusted such that both an SEM image and an FIB image could be observed on the substrate including no droplets. It was confirmed that the temperature of the stage 1 was maintained at about -150°C.

While always confirming the sample temperature, a surface SEM observation was performed on a region including a cross-section observing position of the sample. Based on an image obtained via the surface SEM observation, a substantially central portion of the sample was determined as the cross-section observing position.

Then, an ion beam was irradiated to the cross-section observing position and an SIM image was captured. At that time, the ion beam was irradiated under very weak conditions comparable to those in the observation mode. More specifically, a gallium ion source was used and irradiation conditions were set to the acceleration voltage of 30 kV, the beam current of 20 pA, and the beam diameter of about 30 nm. A precise cross-section machining position was determined from the captured SIM image.

Then, rough machining of the sample was performed at the determined cross-section machining position by the FIB machining apparatus 21. More specifically, a rectangular recess having a 15 µm square part and a depth of 10 µm was formed at the cross-section observation position with the ion acceleration voltage of 30 kV, the beam current of 1 nA, and the beam diameter of about 60 nm. The rough machining was performed under weak conditions, and the cross-section being machined was observed at certain point by the SEM apparatus 22 to confirm that the machining was performed at the desired position. When the machining was substantially completed, the irradiation beam was changed to the electron beam, and the SEM observation of the cross-section was performed after adjusting the electron beam to enable it to scan the machined cross-section at an angle of about 60°.

After confirming that the sample was machined up to the desired position, the irradiation beam was changed to the ion beam to finish the machining process. To increase machining accuracy of the cross-section, this machining was performed on the cross-section machining position, which had been subjected to rough machining, by using a beam thinner than that in the rough machining process under weak conditions comparable to those in the case of the SIM observation. Fig. 14A illustrates the cross-section formed by the FIB machining. There appeared a portion in a part of the sample where the internal structure was exposed by the irradiation of the ion beam. When the magnification was slightly increased, the sample cross-section was confirmed, but the pigment (colorant) in the ink solvent could not be recognized.

Further, a substantially central position of the machined cross-section was selected as the evaluation position.

After adjusting the electron beam on the equivalent machined surface other than the evaluation position, the electron beam was irradiated for about 1 minute primarily at the surface including the evaluation position in a TV scan mode at a magnification of about 20,000.

Thereafter, the SEM observation of the evaluation position was performed at a magnification of about 40,000, and the resulting image was captured.

With the SEM observation, an SEM image containing pigment particles of 100 nm or smaller could be obtained.

At that time, it was confirmed that the stage 1 was held at about -150°C.

Fig. 14B illustrates the cross-section irradiated by the electron beam. By previously irradiating the cross-section including the evaluation position with the electron beam at a high rate of speed for a certain period of time, an SEM image was obtained in which the contour of the nanosized pigment in the ink solvent was clearly recognized while maintaining the dispersion state.

Finally, image processing was executed on the obtained SEM image to emphasize edges of fine portions of the image. As a result, the pigment micro-particles could be easily recognized and the dispersion state thereof could be evaluated.

Thus, according to EXAMPLE 5, as in the second exemplary embodiment, since the FIB processing was performed while the sample temperature was maintained at - 150°C and the electron beam was then radiated on the region including the evaluation position for a certain time, micro-particles in the liquid could be more easily recognized and the SEM image including the micro-particles with clearer contours could be obtained.

### EXAMPLE 6

In EXAMPLE 6, the apparatus illustrated in Fig. 6 was employed. Also, a water-soluble pigment ink containing carbon graphite as a colorant was prepared as a sample. A sample cross-section was evaluated in accordance with the following procedure.

First, the setting temperature was selected as - 145°C. After confirming that the stage 1 was held at the selected evaluation temperature, as in EXAMPLE 5, droplets of the pigment ink were ejected from the head 7 containing the pigment ink toward 3 positions on a sheet of paper pasted to the stage 1.

After confirming the temperature of the stage 1, the enclosed container 11 was depressurized, Ar gas was introduced into the enclosed container 11 through the gas introducing unit 4, and a metal film was coated on the stage 1 by sputtering. A Pt-Pd alloy was used as a sputtering target and an RF power supply was employed. The reduced film thickness was about 10 nm or less.

After again depressurizing the enclosed container 11, the stage coated with the metal film was introduced into the sample chamber 24. Then, the cross-section machining and the SEM observation were performed as in EXAMPLE 5. Since the sample was coated with metal micro-particles, charge build-up on the sample was prevented during the cross-section machining and the SEM observation, and a clear SEM image was observed while maintaining the pigment in the dispersed state.

While the present invention has been described with reference to exemplary embodiments, it is to be understood that the invention is not limited to the disclosed exemplary embodiments. The scope of the following claims is to be accorded the broadest interpretation so as to encompass all modifications and equivalent structures and functions.

## Claims

1. A solid sample (60, 71, 81) comprising a first substance (61), which is in a liquid phase at normal temperature and normal pressure, and a second substance (62), which is different from the first substance and which is in a solid or a liquid phase at the normal temperature and the normal pressure,
wherein the second substance is dispersed in the first substance, and
wherein the solid sample has an amorphous region, and the amorphous region is prepared by converting a droplet, which contains the second substance dispersed in the first substance, into an amorphous state over an entire said region, while maintaining a dispersion state of the second substance in the droplet.

2. The solid sample according to Claim 1, wherein the first substance has a solidifying point -40°C to +20°C.

3. The solid sample according to Claim 1 or 2, wherein the second substance is a pigment and the first substance is water and a water-soluble solvent.

4. The solid sample according to any one of Claims 1 to 3, wherein the solid sample has a height of 1 µm to 10 µm.

5. A solid sample fabricating method including:
preparing a specimen containing a first substance (61), which is in a liquid phase at normal temperature and normal pressure, and a second substance (62), which is different from the first substance and which is in a solid or a liquid phase at the normal temperature and the normal pressure, the second substance being dispersed in the first substance;
attaching the specimen as a droplet to a surface of a cooled stage (1); and
converting an entire region of the specimen into an amorphous state.

6. The solid sample fabricating method according to Claim 5, wherein the droplet is attached to the surface of the cooled stage in a dried gas atmosphere.

7. The solid sample fabricating method according to Claim 5 or 6, wherein the specimen is ejected onto the substrate from an ejection orifice, which is shielded from an ambient atmosphere at least during a period before ejection or after attaching the droplet to the surface.

8. A sample observing method comprising:
fabricating a solid sample (60, 71, 81) by the solid sample fabricating method according to any one of Claims 5 to 7; and
observing a cross-section (73) of the solid sample while maintaining at least a part of the solid sample that is observed in the amorphous state.

9. The sample observing method according to Claim 8, comprising:
exposing the cross-section of the solid sample; and
observing the exposed cross-section after selectively evaporating a part of the first substance from the solid sample.

10. A solid sample fabricating apparatus including:
a stage (1) configured to provide a surface to which a specimen is to be attached;
specimen supply means (7, 13) configured to supply the specimen as a droplet to the surface, the specimen containing a first substance (61), which is in a liquid phase at normal temperature and normal pressure, and a second substance (62), which is different from the first substance and which is in a solid or a liquid phase at the normal temperature and the normal pressure, the second substance being dispersed in the first substance; and
a cooler (6) configured to cool the surface,
wherein the specimen is attached as the droplet to the surface cooled by the cooler, and the specimen droplet is changed into an amorphous state over an entire region to be observed.

11. The solid sample fabricating apparatus according to Claim 10, wherein the specimen supply means is a liquid jet head configured to eject the droplet.

12. The solid sample fabricating apparatus according to Claim 10 or 11, further comprising a shielding unit configured to shield an ejection orifice of the specimen supply means.

13. The solid sample fabricating apparatus according to any one of Claims 10 to 12, wherein the stage includes a moving mechanism (2a, 2b) configured to move the surface in a direction intersecting an ejecting direction of the droplet such that a plurality of droplets are spaced apart on and are attached to the surface.

14. The solid sample fabricating apparatus according to any one of Claims 10 to 13, wherein the stage is separable from the cooler.

15. An observing apparatus including:
the solid sample fabricating apparatus according to any one of Claims 10 to 14;
a cross-section forming apparatus configured to machine a solid sample (60, 71, 81) fabricated by the solid sample fabricating apparatus and to form a cross-section (73) of the solid sample; and
a cross-section observing apparatus configured to observe the cross-section formed by the cross-section forming apparatus while maintaining the solid sample in the amorphous state.
